# EUROPEAN PATENT APPLICATION

(11) **EP 3 446 777 A1**
(43) Date of publication of application: **27.02.2019**
(21) Application number: 18189406.4
(22) Date of filing: 16.08.2018
(51) Int. Cl.: B01F 5/06, B08B 3/10

(54) **DEVICE FOR DIFFUSION OF TEXTURE CLEANING LIQUID**

(30) Priority: 16.08.2017 CN 201721025578 U
(71) Applicant: Beijing Juntai Innovation Technology Co., Ltd, 100176 Beijing (CN)
(72) Inventor: FAN, Huibin, Beijing, 100176 (CN); GUO, Zheng, Beijing, 100176 (CN); CAI, Cen, Beijing, 100176 (CN); WANG, Xudong, Beijing, 100176 (CN); HUANG, Tongyang, Beijing, 100176 (CN)
(74) Representative: Casalonga

(57) **Abstract**

The present application discloses a device for diffusion of texture cleaning liquid, including a tank (100), a first turbulent plate (200) and a second turbulent plate (300). The tank (100) is provided with a liquid inlet (101); the first turbulent plate (200) is fixed to and connected with the tank (100) and is provided with a plurality of first orifices (210) in interval; the second turbulent plate (300) is fixed to and connected with the tank (100) and is provided with a plurality of second orifices (310), and projection of each of the first orifices (210) and projection of each of the second orifices (310) on a plane where the liquid inlet (101) is located are distributed in a alternate manner. The liquid inlet (101), the first turbulent plate (200), and the second turbulent plate (300) are arranged sequentially in a liquid spraying direction.

## Description

### CROSS-REFERENCE TO RELATED APPLICATION

This application claims priority to Chinese Patent Application No. 201721025578.8, filed on August 16, 2017, titled "DEVICE FOR UNIFORM CYCLE OF TEXTURE CLEANING LIQUID", which is incorporated herein by reference in its entirety.

### TECHNICAL FIELD

The present disclosure relates to a technical field of texture cleaning of solar cells, in particular to a device for diffusion of texture cleaning liquid.

### BACKGROUND

In the process of preparing crystalline silicon batteries, a texture cleaning device is a very important process device. During the texture cleaning process, uniform cycle of liquid plays a particularly important role in the pyramid shape after the silicon wafer texture is cleaned. The existing texture cleaning devices are hard to form a standard pyramid shape, resulting in more sunlight reflection on the silicon wafer.

### SUMMARY

Some embodiments of the present disclosure provide a device for diffusion of texture cleaning liquid, including: a tank provided with a liquid inlet; a first turbulent plate which is fixed to and arranged in the tank and which is provided with a plurality of first orifices in interval; a second turbulent plate which is fixed to and arranged in the tank and which is provided with a plurality of second orifices, wherein projection of each of the first orifices and projection of each of the second orifices on a plane where the liquid inlet is located are distributed in a alternate manner; the liquid inlet, the first turbulent plate, and the second turbulent plate are arranged sequentially in a liquid spraying direction.

In some embodiments of the present disclosure, a cross section of the first orifice perpendicular to the axis of the first orifice takes a strip shape; a cross section of the second orifice perpendicular to the axis of the second orifice takes a circular shape.

In some embodiments of the present disclosure, the tank includes a bottom plate and sidewall plates arranged along edges of the bottom plate; the liquid inlet is arranged on the bottom plate; the first turbulent plate and the second turbulent plate are both parallel to the bottom plate; the first turbulent plate and the second turbulent plate are both fixedly connected with the sidewall plates.

In some embodiments of the present disclosure, the plane where the liquid inlet and the bottom plate are located on a same plane being a horizontal plane; projection of each of the first orifices and projection of each of the second orifices on the horizontal plane are distributed in an even and alternate manner.

In some embodiments of the present disclosure, a longitudinal section of the second orifice parallel to the axis of the second orifice takes a trumpet shape, and a diameter of the second orifice increases gradually in the liquid spraying direction.

In some embodiments of the present disclosure, an inlet conduit is fixed and arranged on the liquid inlet, wherein a liquid outlet of the inlet conduit is in connection with the liquid inlet, and a diameter of the inlet conduit increases gradually in the liquid spraying direction.

In some embodiments of the present disclosure, the inlet conduit includes interconnected drainage end and liquid expanding end, wherein a diameter of the drainage end is less than a diameter of the liquid expanding end, and a liquid outlet of the liquid expanding end is connected with the liquid inlet.

In some embodiments of the present disclosure, the liquid outlet of the liquid expanding end is fixed and embedded in the liquid inlet.

In some embodiments of the present disclosure, the inlet conduit and the bottom plate are formed integrally.

In some embodiments of the present disclosure, the number of the inlet conduits is two, the number of the liquid inlets is two, two liquid inlets are disposed on the bottom plate, and each of the liquid inlets is correspondingly connected with one of the inlet conduits.

In some embodiments of the present disclosure, the first turbulent plate is placed in a spraying zone of the inlet conduit.

In some embodiments of the present disclosure, a distance between the first turbulent plate and the liquid inlet is greater than a distance between the first turbulent plate and the second turbulent plate.

In some embodiments of the present disclosure, the first turbulent plate and the second turbulent plate are welded on the tank.

In some embodiments of the present disclosure, the plurality of second orifices are arranged in groups, each group including at least two second orifices.

### BRIEF DESCRIPTION OF THE DRAWINGS

FIG. 1 is a schematic diagram showing the structure of the device for diffusion of texture cleaning liquid as provided in some embodiments of the present disclosure.
FIG. 2 is a front view of the device for diffusion of texture cleaning liquid as illustrated in FIG. 1.
FIG. 3 is a schematic diagram showing the operating principle of the device for diffusion of texture cleaning liquid as provided in some embodiments of the present disclosure.

### DETAILED DESCRIPTION

Embodiments of the present disclosure are described in detail below. Examples of the embodiments are shown in the drawings, wherein identical or similar signs represent identical or similar elements or elements having identical or similar functions throughout the text. The embodiments described below with reference to the drawings are exemplary, only for the purpose of interpreting the present disclosure, and shall not be construed as limiting the present disclosure.

At present, solar cells are mainly silicon solar cells and thin-film solar cells. For silicon solar cells, the silicon wafer needs to be cleaned after a series of processing procedures in order to eliminate all kinds of contaminants on the surface of the silicon wafer and to produce a textured structure (i.e., texturing) that can reduce sunlight reflection of the surface. Texturing is an important process for manufacturing silicon solar cells, which is also called "surface texturing". The effective textured structure makes the incident light reflected and refracted many times on the surface of the silicon wafer, increasing the absorption of light, reducing the reflectivity, and helping to improve the performance of the solar cells.

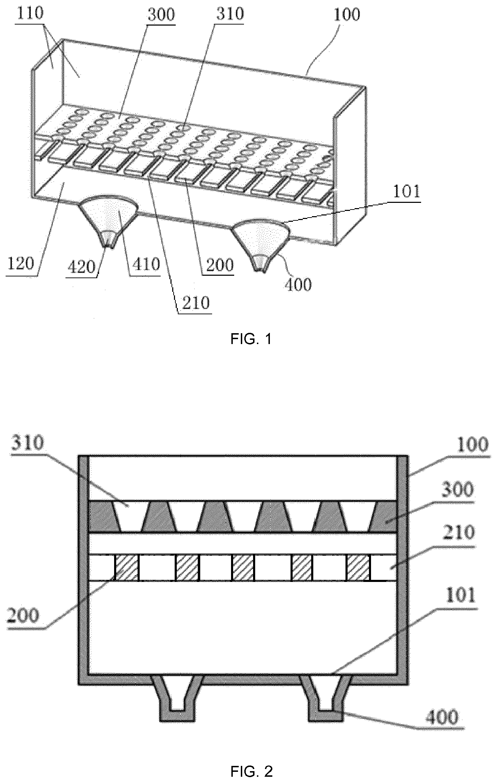

Referring to FIG. 1, FIG. 2 and FIG. 3 simultaneously, some embodiments of the present disclosure provide a device for diffusion of texture cleaning liquid, which includes a tank 100, a first turbulent plate 200, and a second turbulent plate 300; the tank 100 is provided with a liquid inlet 101; the first turbulent plate 200 is fixed to and connected with the tank 100, and a plurality of first orifices 210 are arranged in interval on the first turbulent plate 200; the second turbulent plate 300 is fixed to and connected with the tank 100, a plurality of second orifices 310 are arranged on the second turbulent plate 300; and projection of each of the first orifices 210 and projection of each of the second orifices 310 on a plane where the liquid inlet 101 is located are distributed in a alternate manner; the liquid inlet 101, the first turbulent plate 200, and the second turbulent plate 300 are arranged sequentially in a liquid spraying direction.

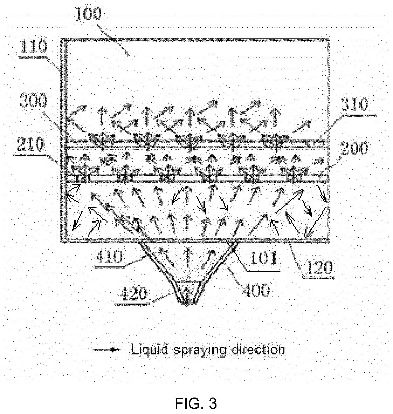

When silicon wafers are etched by using the device for diffusion of texture cleaning liquid as provided in some embodiments of the present disclosure, the liquid can enter the tank 100 through the liquid inlet 101, as shown in FIG. 3. Since the liquid sprayed from the liquid inlet 101 has some pressure, the liquid can enter the zone between the first turbulent plate 200 and the second turbulent plate 300 through a plurality of first orifices 210 on the first turbulent plate 200. since the liquid is sprayed into the tank 100 in a dispersing manner, the liquid can rebound after colliding with inner walls of the plurality of first orifices 210 when the liquid sprayed along an oblique line enters the plurality of first orifices 210, or the liquid sprayed along an oblique line can rebound after colliding with the tank 100, thereby the liquid entering the zone between the first turbulent plate 200 and the second turbulent plate 300 may have different spraying directions, so as to scatter the liquid, and the flow rate of the scattered liquid is also increased. In addition, a second turbulent plate 300 is provided in the liquid spraying direction, thereby the liquid having passed through the plurality of first orifices 210 continues passing through a plurality of second orifices 310 on the second turbulent plate 300. And projection of each of the first orifices 210 and projection of each of the second orifices 310 on a plane where the liquid inlet 101 is located are distributed in a mutually alternate manner, so as to achieve the effect that the liquid sprayed from the plurality of first orifices 210 is dispersed evenly after passing through the plurality of second orifices 310.

In some embodiments of the present disclosure, the first turbulent plate 200 and the second turbulent plate 300 are parallel.

Each of the first orifices 210 is a strip-shaped hole. "Strip-shaped hole" means that the cross section perpendicular to an axis of a first orifice 210 is stripe-shaped. As compared with the second turbulent plate 300, the first turbulent plate 200 is arranged closer to the liquid inlet 101, therefore the first turbulent plate 200 is equivalent to primary turbulence, and the second turbulent plate 300 is equivalent to secondary turbulence. The aperture of each of the first orifices 210 on the first turbulent plate 200 in primary turbulence is greater than the aperture of each of the second orifices 310 on the second turbulent plate 300 in secondary turbulence.

Each of the second orifices 310 is a circular hole. "Circular hole" means that the cross section perpendicular to an axis of a second orifice 310 is circle. In secondary turbulence, to further improve the turbulent effect, the diameter of each of the second orifices 310 on the second turbulent plate 300 is less than the diameter of each of the first orifices 210 on the first turbulent plate 200 in primary turbulence.

In some embodiments of the present disclosure, as shown in FIG. 1, the tank 100 has following structures, including a bottom plate 120 and sidewall plates 110 arranged along edges of the bottom plate 120. The liquid inlet 101 is arranged on the bottom plate 120. The first turbulent plate 200 and the second turbulent plate 300 are both parallel to the bottom plate 120, and are both fixed to and connected with the sidewall plate 110. The first turbulent plate 200 is located between the bottom plate 120 and the second turbulent plate 300.

In some embodiments of the present disclosure, the first turbulent plate 200 and the second turbulent plate 300 are arranged perpendicularly to the liquid spraying direction, which shortens the flow path of the liquid, such that the liquid can pass through the first orifice 210 and the second orifice 310 at a certain flow rate, so as to improve the turbulent effect and strengthen the evenness.

The liquid inlet 101 and the bottom plate 120 are located on the same plane, and under the condition of normal placement, the plane where the liquid inlet 101 is located is a horizontal plane. Projection of each of the first orifices 210 and projection of each of second orifices 310 on the horizontal plane are distributed in an even and alternate manner. For example, the distance between the projection of one first orifice 210 and the projection of one adjacent second orifice 310 on the horizontal plane is same. Namely, the distance between two adjacent projections may be same.

In some embodiments of the present disclosure, each of second orifices 310 is a trumpet-shaped hole. The "trumpet-shaped hole" means that the longitudinal section parallel to the axis of the second orifice 310 takes a trumpet shape, and the diameter of the trumpet-shaped hole increases gradually in the liquid spraying direction, thereby reducing the flow rate of the liquid in some degree, further improving the uniformity of the liquid, and ensuring the etching quality of the silicon wafer.

In some embodiments of the present disclosure, a distance between the first turbulent plate 200 and the bottom plate 120 may be greater than a distance between the first turbulent plate 200 and the second turbulent plate 300. Considering the liquid sprayed from the liquid inlet 101 has a high speed and is centered partially to disable uniformity of silicon etching, therefore the distance between the first turbulent plate 200 and the bottom plate 120 is greater than the distance between the first turbulent plate 200 and the second turbulent plate 300, such that the flow rate of the liquid may be attenuated gradually during the movement toward the first turbulent plate 200. Then the liquid may be scattered under the action of the first turbulent plate 200, and a flow rate of the scattered liquid may be increased, such that the scattered liquid could have enough speed to pass through the second turbulent plate 300.

In some embodiments of the present disclosure, the first turbulent plate 200 and the second turbulent plate 300 are fixed to and connected with the tank 100, for example, fixed to and connected with the sidewall plates 110 of the tank 100. To ensure that the first turbulent plate 200 and the second turbulent plate 300 are fixed reliably on the sidewall plate 110 of the tank 100, the first turbulent plate 200 and the second turbulent plate 300 can be welded on the sidewall plates 110 of the tank 100.

In some embodiments of the present disclosure, an inlet conduit 400 is fixed and arranged on the liquid inlet 101 of the bottom plate 120, a liquid outlet of the inlet conduit 400 is in connection with the liquid inlet 101 on the tank 100. A diameter of the inlet conduit 400 increases gradually in the liquid spraying direction, so as to reduce the flow rate of the liquid outputted from the inlet conduit 400 and at the same time to make the liquid be sprayed into the tank 100 in a dispersing manner, so that the first turbulence plate 200 can further disperse the liquid.

In some embodiments of the present disclosure, the inlet conduit 400 may be configured into a funnel shape, and it may include interconnected a liquid expanding end 410 and a drainage end 420. A liquid outlet of the liquid expanding end 410 is connected with the liquid inlet 101 of the tank 100, and the diameter of the drainage end 420 is less than the diameter of the liquid expanding end 410. Based on this, the inlet conduit 400 may be connected with a liquid supply device through the drainage end 420, and make the liquid accumulate a certain amount of energy in the drainage end 420. Since the diameter of the drainage end 420 is less than the diameter of the liquid expanding end 410, energy accumulated in the drainage end 420 is released when the liquid begins to flow to the liquid expanding end 410 from the drainage end 420, and the liquid is sprayed out, so that the liquid obtain a certain flow rate.

The inlet conduit 400 may be welded on the surface of the bottom plate 120. However, when defects such as a crack occurred on the weld, the liquid may overflow from the crack where the inlet conduit 400 and the tank 100 are connected during the spraying process. To prevent this problem, the liquid outlet of the liquid expanding end 410 may be fixed and embedded in the liquid inlet 101, such that the liquid outlet of the liquid expanding end 410 extends to an inner chamber of the tank 100, thereby the liquid does not pass through the joint between the liquid expanding end 410 and the tank 100 in its spraying direction. For example, the liquid outlet of the liquid expanding end 410 may be provided with an external thread, and the inner wall of the liquid inlet 101 may be provided with an internal thread that matches with the external thread, thereby the liquid outlet of the liquid expanding end 410 can be directly screwed into the liquid inlet 101. Of course, optionally the bottom plate 120 and the inlet conduit 400 may be formed integrally, thereby avoiding the problem that the liquid overflows from the joint.

In some embodiments of the present disclosure, the number of the inlet conduits 400 can be more than one, and the number of the liquid inlets 101 also can be more than one. Each of the liquid inlets 101 is correspondingly connected with one of the inlet conduits 400. And the liquid inlets 101 are distributed evenly on the bottom plate 120.

In some embodiments of the present disclosure, the number of the inlet conduits 400 may be two, accordingly the number of the liquid inlets 101 is also two. The two liquid inlets 101 are disposed on the bottom plate 120, and each of the liquid inlets 101 is correspondingly connected with one of the inlet conduits 400, thereby uniformity of liquid spraying can be improved.

In some embodiments of the present disclosure, the first turbulent plate 200 is placed in a spraying zone of the inlet conduits 400. An outer wall of the liquid expanding end 410 takes a conical shape, e.g. a funnel shape, and a spraying zone of the liquid expanding end 410 is formed as the spraying zone of the inlet conduits 400. The first turbulent plate 200 is placed in the spraying zone, therefore, ensuring that the liquid sprayed out from the liquid expanding end 410 comes into contact with every first orifices 210 of the first turbulent plate 200, so as to achieve uniform dispersing of the liquid.

It can be understood that when only one liquid inlet 101 is provided and one inlet conduit 400 is connected with this liquid inlet 101, a spraying zone can be formed among the extension surfaces of outer walls of liquid expanding end 410 of this inlet conduit 400.

The plurality of second orifices 310 can be arranged in groups, each group including at least two second orifices 310. The at least two second orifices 310 in each group are arranged in a line, circle, ellipse, or polygon, as long as they are staggered with each of the first orifices 210 in arrangement. For example, in some embodiments of the present disclosure, as shown in FIG. 1, the at least two second orifices 310 in one group are arranged in a line; therefore, there are a total of 11 groups of second orifices 310 are visible in FIG. 1.

The device for diffusion of texture cleaning liquid as provided in some embodiments of the present disclosure makes the liquid more uniform during the cycle through the arranged first and second turbulent plates, ensuring that the liquid contacts the silicon surface uniformly during the process of silicon texturing and cleaning, which improves the batch stability and quality conformance of the pyramid after silicon texturing and cleaning.

The above embodiments with reference to the drawings describe the structures, features, functions and effects of the present disclosure in detail. The above embodiments are only preferred embodiments of the present disclosure, but the scope of application in the present disclosure is not limited by the above embodiments. Any change made in accordance with the concept of the present disclosure or equivalent embodiment modified as an identical change in the spirit of the specification and drawings shall be included in the scope of protection of the present disclosure.

## Claims

1. A device for diffusion of texture cleaning liquid, wherein the device comprises:
a tank (100) provided with a liquid inlet (101);
a first turbulent plate (200) fixed to and arranged in the tank (100) and provided with a plurality of first orifices (210) in interval;
a second turbulent plate (300) fixed to and arranged in the tank (100) and provided with a plurality of second orifices (310), projection of each of the first orifices (210) and projection of each of the second orifices (310) on a plane where the liquid inlet (101) is located are distributed in a alternate manner; and
the liquid inlet (101), the first turbulent plate (200), and the second turbulent plate (300) are arranged sequentially in a liquid spraying direction.

2. The device for diffusion of texture cleaning liquid according to claim 1, wherein
a cross section of the first orifice (210) perpendicular to an axis of the first orifice (210) takes a strip shape; and
a cross section of the second orifice (310) perpendicular to an axis of the second orifice (310) takes a circular shape.

3. The device for diffusion of texture cleaning liquid according to claim 1 or 2, wherein
the tank (100) comprises a bottom plate (120) and sidewall plates (110) arranged along edges of the bottom plate (120);
the liquid inlet (101) is arranged on the bottom plate (120);
the first turbulent plate (200) and the second turbulent plate (300) are both parallel to the bottom plate (120);
the first turbulent plate (200) and the second turbulent plate (300) are both fixed to and connected with the sidewall plates (110).

4. The device for diffusion of texture cleaning liquid according to claim 3, wherein the liquid inlet (101) and the bottom plate (120) are located on a same plane being a horizontal plane;
projection of each of the first orifices (210) and projection of each of the second orifices (310) on the horizontal plane are distributed in an even and alternate manner.

5. The device for diffusion of texture cleaning liquid according to any one of claims 1-4, wherein a longitudinal section of the second orifice (310) parallel to an axis of the second orifice (310) takes a trumpet shape, and a diameter of the second orifice (310) increases gradually in the liquid spraying direction.

6. The device for diffusion of texture cleaning liquid according to any one of claims 1-4, wherein an inlet conduit (400) is fixed and arranged on the liquid inlet (101), and a liquid outlet of the inlet conduit (400) is in connection with the liquid inlet (101), and a diameter of the inlet conduit (40) increases gradually in the liquid spraying direction.

7. The device for diffusion of texture cleaning liquid according to claim 6, wherein the inlet conduit (400) comprises interconnected drainage end (420) and liquid expanding end (410), and a liquid outlet of the liquid expanding end (410) is connected with the liquid inlet (101).

8. The device for diffusion of texture cleaning liquid according to claim 7, wherein the liquid outlet of the liquid expanding end (410) is fixed and embedded in the liquid inlet (101).

9. The device for diffusion of texture cleaning liquid according to any one of claims 6-8, wherein the number of the inlet conduits (400) is two, the number of the liquid inlets (101) is two, two liquid inlets (101) are disposed on the bottom plate (120), and each of the liquid inlets (101) is correspondingly connected with one of the inlet conduits (400).

10. The device for diffusion of texture cleaning liquid according to any one of claims 6-9, wherein the first turbulent plate (200) is placed in a spraying zone of the inlet conduit (400).

11. The device for diffusion of texture cleaning liquid according to any one of claims 1-10, wherein a distance between the first turbulent plate (200) and the liquid inlet (101) is greater than a distance between the first turbulent plate (200) and the second turbulent plate (300).

12. The device for diffusion of texture cleaning liquid according to any one of claims 1-11, wherein the first turbulent plate (200) and the second turbulent plate (300) are welded on the tank (100).

13. The device for diffusion of texture cleaning liquid according to any one of claims 1-12, wherein the plurality of second orifices (310) are arranged in groups, each group comprising at least two of second orifices (310).
